# EUROPÄISCHE PATENTANMELDUNG

(11) **EP 1 534 050 A1**
(43) Veröffentlichungstag der Anmeldung: **25.05.2005**
(21) Anmeldenummer: 04027389.8
(22) Anmeldetag: 18.11.2004
(51) Int. Cl.: H05K 1/02, H05K 3/46

(54) **Verfahren zur Herstellung von Leiterplatten und Leiterplatte**

(30) Priorität: 19.11.2003 DE 10354118
(71) Anmelder: Ruwel AG, 47608 Geldern (DE)
(72) Erfinder: Ebeling, Ralf, 47623 Kevelaer (DE); van der Kruijs, Ad, 5581 TL Waalre (NL)
(74) Vertreter: Gesthuysen, von Rohr & Eggert

(57) **Zusammenfassung**

Dargestellt und beschrieben ist eine Leiterplatte (1) mit einem Basismaterial (2) aus Isolierstoff als Träger von Leiterbahnen (3), wobei die fertigen Leiterbahnen (3) eine Dicke von mindestens 100 µm aufweisen, sowie ein Verfahren zur Herstellung einer derartigen Leiterplatte (1).

Mit dem erfindungsgemäßen Verfahren kann eine Leiterplatte (1) durch folgende Schritte sehr einfach und zuverlässig hergestellt werden:
- Strukturieren der Leiterfolienschicht zur Erzeugung der Leiterbahnen (3),
- Verpressen mit einem isolierenden Füllmaterials (8), so daß sowohl die Kanäle (4) zwischen den Leiterbahnen (3) mit dem Füllmaterial (8) vollständig gefüllt als auch die Oberfläche (9) der Leiterbahnen (3) von dem Füllmaterial (8) bedeckt sind und
- Anbinden der im Inneren der Leiterplatte (1) angeordneten Leiterbahnen (3) an Anschlußflächen (11) auf der Oberfläche der Leiterplatte (1) durch Bohren und Metallisieren von Löchern (10).

## Beschreibung

Die Erfindung betrifft ein Verfahren zur Herstellung von Leiterplatten mit mindestens einem Basismaterial aus Isolierstoff als Träger von Leiterbahnen, wobei die fertigen Leiterbahnen eine Dicke von mindestens 100 µm aufweisen und wobei zunächst auf mindestens einer Seite des Basismaterials eine Leiterfolienschicht aufgebracht wird. Daneben betrifft die Erfindung auch eine Leiterplatte mit mindestens einem Basismaterial aus Isolierstoff als Träger von Leiterbahnen, wobei die fertigen Leiterbahnen eine Dicke von mindestens 100 µm aufweisen.

Schon seit vielen Jahrzehnten werden Leiterplatten, die häufig auch als gedruckte elektrische Schaltungen bezeichnet werden, in elektrischen Geräten und in Kraftfahrzeugen zur elektronischen Regelung und Steuerung eingesetzt. Es handelt sich hierbei üblicherweise um starre Leiterplatten, die einerseits diskrete Bauelemente und hochintegrierte Bausteine elektrisch miteinander verbinden und andererseits als Träger derselben fungieren. Die Leiterplatten bestehen zumeist aus einer oder mehreren Einzellagen aus glasfaserverstärkten, ausgehärteten Epoxydharzplatten, die zur Ausbildung von Leiterbahnen bzw. Leiterbildem ein- oder beidseitig kupferkaschiert sind. Bei mehrlagigen Leiterplatten, die auch als Multilayer bezeichnet werden, sind die einzelnen Ebenen bzw. die auf den Einzellagen angeordneten Leiterbahnen durch metallisierte Bohrungen in der Leiterplatte miteinander elektrisch verbunden.

Seit ca. 30 Jahre werden neben rein starren Leiterplatten auch gedruckte Schaltungen eingesetzt, die nebeneinander starre und flexible Bereiche aufweisen; sogenannte starr-flexible Leiterplatten. Durch das Vorsehen von flexiblen Bereichen kann eine größere Anzahl von starren Leiterplatten in nahezu jeder gewünschten räumlichen Anordnung ohne Steckerleisten oder Verdrahtungen mechanisch und elektrisch miteinander verbunden werden. Darüber hinaus bieten die flexiblen Bereiche die Möglichkeit, mehrere starre Leiterplattenbereiche so "übereinander zu falten", daß eine große Leiterplattenfläche und damit auch eine Vielzahl von auf den Leiterplatten angeordneten diskreten Bauelemente auf einem relativ kleinen Raum untergebracht werden können. Die flexiblen Bereiche bestehen normalerweise aus dünnen Polyimidfolien, die ebenfalls ein- oder beidseitig kupferkaschiert sind.

Das Basismaterial, das häufig auch als Basislaminat bezeichnet wird, besteht in der Regel aus Polymerschichten, die mit Füllmaterialien versteift werden. In der Praxis wird dabei als Basismaterial ein mit Epoxydharz getränktes Glasgewebe verwendet, das als FR 4-Material bezeichnet wird. Zur Herstellung des jeweiligen Leiterbildes wird die auf dem Basismaterial aufgebrachte Leiterfolienschicht in gewünschter Weise strukturiert, wobei als Leiterfolienschicht in der Regel eine Kupferfolie verwendet wird. Das so erzeugte, auf der Oberfläche der Leiterplatte angeordnete Leiterbahnenbild wird dann mit einer strukturierten Lackschicht, die als Lötstoppmaske bezeichnet wird, bedruckt, wobei nur die Lötflächen bzw. die Bauelementeanschlüsse frei bleiben. Die Lötstoppmaske dient dabei insbesondere zur Vermeidung von Kurzschlüssen zwischen benachbarten Leiterbahnen.

Die eingangs beschriebenen Leiterplatten, bei denen die fertigen Leiterbahnen eine Dicke von mindestens 100 µm aufweisen, werden insbesondere dort eingesetzt, wo größere Ströme von mehreren Ampere übertragen werden müssen. Derartige Leiterplatten, die bei Verwendung einer Kupferfolie als Leiterfolienschicht auch als Dickkupferschaltungen bezeichnet werden, werden in zunehmendem Maße insbesondere in Kraftfahrzeugen eingesetzt. Die gewünschte größere Dicke der Leiterbahnen wird dabei zunächst dadurch erreicht, daß das Basismaterial mit einer Kupferfolie mit einer entsprechenden Dicke beschichtet ist. Darüber hinaus kann die Dicke der Leiterbahnen durch galvanische Verkupferung bis zur Sollstärke weiter erhöht werden, wozu zunächst ein entsprechendes Plattierungsresist auf die Kupferfolie aufgedruckt wird. Anschließend wird das gewünschte Leiterbahnenbild durch bekannte Ätzverfahren hergestellt.

Zum Schutz derartiger Leiterplatten gegen Umwelteinflüsse, insbesondere gegen Feuchtigkeit und mechanische Beanspruchungen, werden die Zwischenräume zwischen den Leiterbahnen mit einem isolierenden Lack, insbesondere einem Lötstopplack, gefüllt.

Problematisch beim Aufbringen des Lötstopplacks, was in der Regel im Siebdruckverfahren erfolgt, ist die durch die gewollte Dicke der Leiterbahnen bedingte Tiefe der Zwischenräume, d. h. der Kanäle zwischen den Leiterbahnen. Diese Kanäle können nur sehr schwer im bekannten Siebdruckverfahren vollständig mit Lötstopplack gefüllt werden, so daß hierzu in der Regel mehrere Druckverfahren erforderlich sind, wobei jedesmal die Gefahr besteht, daß kleine Luftbläschen beim Druck eingeschlossen werden. Auch ist eine zuverlässige Kantenabdeckung der Leiterbahnen mit bekannten Druckverfahren nur schwer erreichbar, wobei gerade die Kanten der Leiterbahnen den Umwelteinflüssen am stärksten ausgesetzt sind..

Eine Leiterplatte, mit Leiterbahnen deren Dicke in der Größenordnung von 400 - 1000 µm liegt, ist beispielsweise aus der DE 101 21 673 A1 bekannt. Bei der bekannten Leiterplatte wird als Lack bevorzugt eine UV-aushärtender Lack verwendet. Der Lack soll dabei eine größtmögliche Haftung an den Leiterbahnen, dem Basismaterial und an der auf die Anordnung aufgebrachten Lötstoppmaske aufweisen, ohne daß in dieser Druckschrift näher angegeben wird, wie dies erreicht werden soll.

Der vorliegenden Erfindung liegt daher die Aufgabe zugrunde, ein Verfahren anzugeben, mit dem Leiterplatten, die Leiterbahnen mit einer Dicke von mindestens 100 µm aufweisen, einfach und zuverlässig hergestellt werden können. Darüber hinaus soll eine eingangs beschriebene Leiterplatte zur Verfügung gestellt werden, die gegenüber Umwelteinflüssen wie Feuchtigkeit widerstandfähig ist und vielseitig eingesetzt werden kann.

Diese Aufgabe ist bei dem eingangs beschriebenen Verfahren im wesentlichen durch folgende Schritte gelöst:
- Strukturieren der Leiterfolienschicht zur Erzeugung der Leiterbahnen,
- Verpressen mit einem isolierenden Füllmaterial, so daß sowohl die Kanäle zwischen den Leiterbahnen mit dem Füllmaterial vollständig gefüllt als auch die Oberfläche der Leiterbahnen von dem Füllmaterial bedeckt sind und
- Anbinden der im Inneren der Leiterplatte angeordneten Leiterbahnen an Anschlußflächen auf der Oberfläche der Leiterplatte durch Bohren und Metallisieren von Löchern.

Die mit dem erfindungsgemäßen Verfahren hergestellte Leiterplatte unterscheidet sich zunächst dadurch wesentlich von den bekannten Leiterplatten, daß das Leiterbahnenbild ins Innere der Leiterplatte verlegt worden ist. Dies setzt zunächst eine Layoutanpassung voraus, da die einzelnen Leiterbahnen nicht mehr unmittelbar auf der Oberfläche der Leiterplatte sondern nur noch über die metallisierten Löcher elektrisch kontaktiert werden können. Durch das Verpressen der strukturierten Leiterfolienschicht mit den isolierenden Füllmaterial wird sowohl ein luftfreies Auffüllen der tiefen Kanäle zwischen den Leiterbahnen als auch eine gute Kantenabdeckung der einzelnen Leiterbahnen erreicht. Außerdem kann eine gleichmäßige Abdeckung des gesamten Leiterbildes sehr einfach realisiert werden, so daß auch das Anschließende Aufbringen einer Lötstoppmaske nicht erforderlich ist.

Zum Anbinden der im Inneren der Leiterplatte angeordneten Leiterbahnen an Anschlußflächen auf der Oberfläche der Leiterplatte werden - wie zuvor ausgeführt und wie im Stand der Technik für sich bekannt - Löcher in die Leiterplatte gebohrt, deren Lochwandungen anschließend metallisiert werden. Zur Erzeugung der Anschlußflächen auf der Oberfläche der Leiterplatte kann eine leitfähige Paste aufgebracht werden, die auch zur Metallisierung der Löcher verwendet werden kann.

*Gemäß einer bevorzugten Ausgestaltung des erfindungsgemäßen Verfahrens, bei dem als Füllmaterial ein einseitig mit einer Leiterfolienschicht beschichtetes Prepreg verwendet wird,* erfolgt die Erzeugung der Anschlußflächen durch eine Strukturierung der auf dem Prepreg aufgebrachten Leiterfolienschicht. Im einzelnen können dabei folgende Schritte durchgeführt werden:
- Drucken eines Plattierungsresists,
- galvanische Verkupferung bis zur Sollstärke,
- Abscheiden eines Metallresists,
- Strippen des Plattierungsresists und
- Ätzen der Anschlußflächen.

Dabei ist es nicht erforderlich, daß sämtliche der zuvor genannten Schritte zur Erzeugung der Anschlußflächen durchgeführt werden. Ist beispielsweise die Dicke der auf dem Prepreg aufgebrachten Kupferfolie ausreichend groß, so können die galvanische Verkupferung und somit auch der Druck des Plattierungsresists entfallen.

Bei der eingangs beschriebene Leiterplatte ist die zuvor genannte Aufgabe dadurch gelöst, daß ein isolierendes Füllmaterial so auf dem Basismaterial bzw. den Leiterbahnen aufgebracht ist, daß sowohl die Kanäle zwischen den Leiterbahnen mit dem Füllmaterial vollständig gefüllt als auch die Oberfläche der Leiterbahnen von dem Füllmaterial bedeckt sind, und daß Löcher in der Leiterplatte vorgesehen sind, deren Lochwandungen metallisiert sind, so daß die im Inneren der Leiterplatte angeordneten Leiterbahnen elektrisch leitend mit Anschlußflächen auf der Oberfläche der Leiterplatte verbindbar sind.

Bei der erfindungsgemäßen Leiterplatte ist die gute Beständigkeit gegen Umwelteinflüsse wie Feuchtigkeit insbesondere dadurch gewährleistet, daß die Leiterbahnen sowohl von der Seite als auch von oben durchgängig von dem Füllmaterial bedeckt sind, so daß insbesondere an den beim Lötstoppdruck kritischen Kanten der Leiterbahnen eine zuverlässige Abdeckung gewährleistet ist.

Gemäß einer bevorzugten Ausgestaltung der erfindungsgemäßen Leiterplatte ist das Füllmaterial als Prepreg ausgebildet, wobei das Prepreg auf der dem Basismaterial abgewandten Seite eine Leiterfolienschicht aufweist. Die Leiterfolienschicht kann dabei, wie zuvor im Zusammenhang mit dem erfindungsgemäßen Verfahren ausgeführt, zur Erzeugung der Anschlußflächen benutzt werden.

Bei der bevorzugten Verwendung sowohl eines Basismaterials als auch eines Prepregs aus Epoxydharz und Glasfasergewebe besteht die Leiterplatte insgesamt aus einem sehr homogenen Dielektrikum, so daß sich das Basismaterials und das Prepreg bei wechselnden Umgebungsbedingungen, insbesondere bei hohen Temperaturen, nahezu identisch verhalten, so daß es nicht zu unterschiedlichen Materialausdehnungen und damit zu Spannungen innerhalb der Leiterplatte kommt. Darüber hinaus hat die Verwendung eines Prepregs, das aus einem epoxydharzgetränkten Glasfasergewebe besteht, als Füllmaterial gegenüber der Verwendung eines Lötstopplacks den Vorteil, daß eine höhere Dauertemperaturbelastbarkeit erreichbar ist. Bei Verwendung entsprechender Epoxydharze ist beispielsweise eine Dauertemperaturbelastbarkeit von mehr als 130° C erreichbar, was bei der weiteren Verarbeitung, insbesondere der Bestückung, der Leiterplatte vorteilhaft ist.

Im einzelnen gibt es nun eine Vielzahl von Möglichkeiten, das erfindungsgemäße Verfahren bzw. die erfindungsgemäße Leiterplatte auszugestalten und weiterzubilden. Hierzu wird verwiesen einerseits auf die den Patentansprüchen 1 und 6 nachgeordneten Patentansprüche, andererseits auf die nachfolgende Beschreibung eines bevorzugten Ausführungsbeispiels in Verbindung mit der Zeichnung. In der Zeichnung zeigen
- Fig. 1: eine schematische Darstellung einzelner Schritte eines aus dem Stand der Technik bekannten Verfahrens zur Herstellung von Leiterplatten und
- Fig. 2: eine schematische Darstellung einzelner Schritte des erfindungsgemäßen Verfahrens zur Herstellung von Leiterplatten.

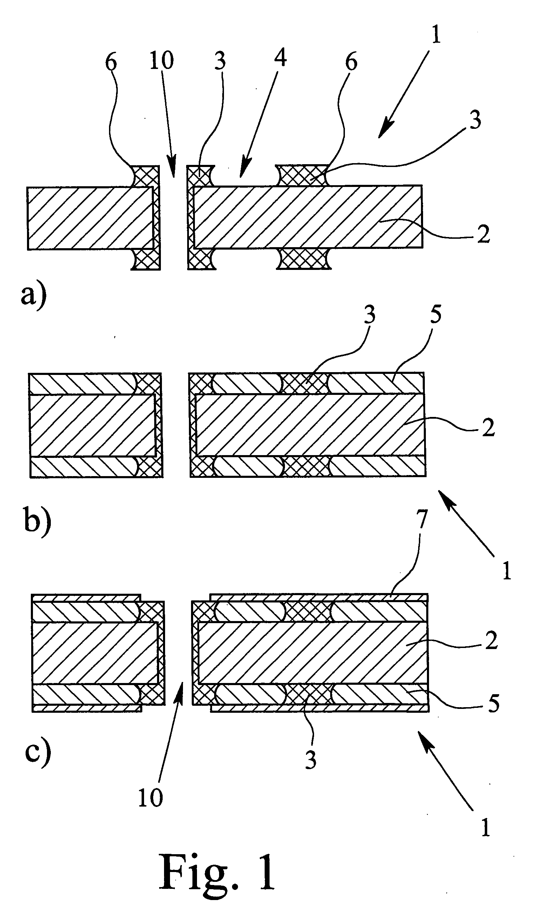

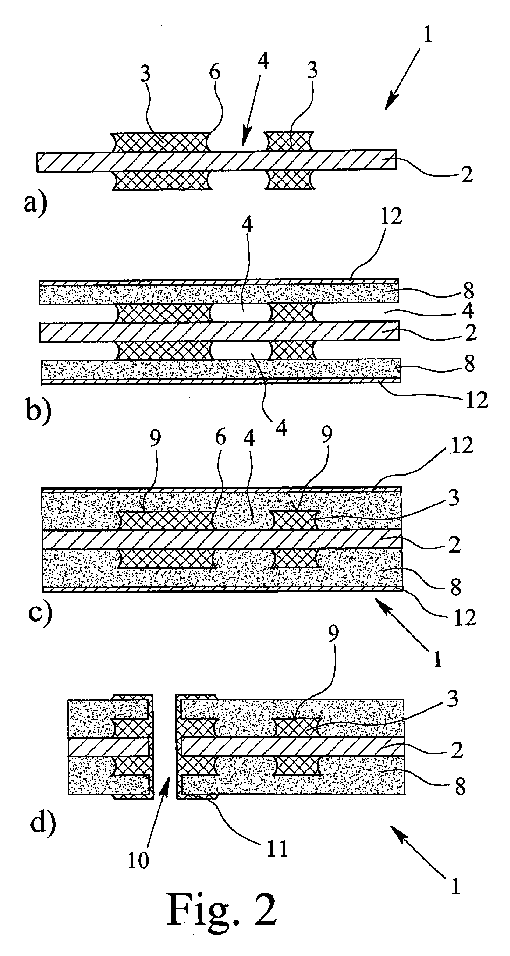

Die Fig. 1 und 2 zeigen einzelne Verfahrensschritte zur Herstellung einer Leiterplatte 1, die zunächst ein Basismaterial 2 aus Isolierstoff, insbesondere aus FR 4-Material als Träger von Leiterbahnen 3 aufweist, wobei die fertigen Leiterbahnen 3 eine Dicke von mindestens 100 µm aufweisen. Bei der erfindungsgemäßen Leiterplatte 1 weisen die Leiterbahnen 3 vorzugsweise eine Dicke von ca. 200 µm auf.

Bei dem aus dem Stand der Technik bekannten Verfahren, das in Fig. 1 dargestellt ist, erfolgt zunächst die Lochbildherstellung sowie die Metallisierung der Lochwandungen. Anschließend erfolgt die Herstellung des Leiterbahnbildes, wozu zunächst ein Plattierungsresist auf das mit Kupferfolie beschichtete Basismaterial aufgebracht wird. Durch das Plattierungsresist werden die Stellen der Kupferfolie abgedeckt, die nicht zu dem gewünschten Leiterbahnbild gehören. Anschließend wird galvanisch auf Sollstärke verkupfert und dann die so erzeugten Leiterbahnen mit einem Metallresist abgedeckt. Als nächstes folgt dann das Strippen des Plattierungsresists sowie das Ätzen der eigentlichen Leiterbahnen. Das Ergebnis dieser zuvor beschriebenen Verfahrensschritte ist in Fig. 1a dargestellt.

Zum Auffüllen der Kanäle 4 zwischen den einzelnen Leiterbahnen 3 wird anschließend in einem oder mehreren Siebdruckverfahren ein Lötstopplack 5 aufgebracht, wobei aufgrund der Tiefe der Kanäle die Gefahr besteht, daß kleine Luftblasen in dem Lötstopplack 5 eingeschlossen werden und die Kanten 6 der Leiterbahnen 3 nur unzureichend abgedeckt werden. Dieser Verfahrensschritt ist in Fig. 1b dargestellt.

Gemäß dem in Fig. 1c dargestellten weiteren Verfahrensschritt erfolgt dann ein Bedrucken der Leiterplatte 1 mit einer Lötstoppmaske 7 um Kurzschlüsse zwischen benachbarten Leiterbahnen 3 zu verhindern. Bei dem bekannten Verfahren ist insbesondere das Auffüllen der Kanäle 4 zwischen den einzelnen Leiterbahnen 3 sehr aufwendig, wobei darüber hinaus die Gefahr besteht, daß Lötstopplack 5 in den Bereich der metallisierten Bohrungen 10 gelangt.

Im Unterschied zu dem zuvor beschriebenen Verfahren erfolgt bei dem in Fig. 2 dargestellten erfindungsgemäßen Verfahren zunächst - hier nicht dargestellt - eine Strukturierung der auf dem Basismaterial 2 aufgebrachten Leiterfolienschicht zur Erzeugung der Leiterbahnen 3. Die Strukturierung wird dabei in der Regel durch Ätzen erreicht, wobei darüber hinaus gegebenenfalls auch die im Zusammenhang mit dem bekannten Verfahren zuvor beschriebenen Schritte zur Herstellung des Leiterbahnbildes - Druck eines Plattierungsresistes, galvanische Verkupferung auf Sollstärke, Abscheiden eines Metallresists und Strippen des Plattierungsresists - zusätzlich durchgeführt werden können. Die Leiterplatte 1 mit den fertigen Leiterbahnen 3 ist in Fig. 2a dargestellt. Die Leiterbahnen 3 weisen dabei eine Dicke von ca. 200 µm auf, wobei jedoch auch größere Dicken möglich sind.

In einem nächsten Schritt wird dann ein Prepreg 8 so mit der Leiterplatte 1 verpreßt, daß sowohl die Kanäle 4 zwischen den Leiterbahnen 3 mit dem Prepreg 8 vollständig gefüllt als auch die Oberfläche 9 der Leiterbahnen 3 von dem Prepreg bedeckt sind. Dieser Verfahrensschritt ist in Fig. 2b und 2c dargestellt. Da nach dem Verpressen der Leiterplatte 1 mit dem Prepreg 8 die Leiterbahnen 3 im Inneren der Leiterplatte 1 angeordnet sind, werden in einem weiteren Schritt Löcher 10 in die Leiterplatte 1 gebohrt, deren Lochwandungen metallisiert werden, so daß die im Inneren der Leiterplatte 1 angeordneten Leiterbahnen 3 elektrisch leitend mit Anschlußflächen 11 auf der Oberfläche der Leiterplatte 1 verbindbar sind.

Wie in den Fig. 2b und 2c zu erkennen ist, weist das Prepreg 8 vorzugsweise auf der dem Basismaterial 2 abgewandten Seite eine Leiterfolienschicht 12 auf. Die Leiterfolienschicht 12 kann dann dazu benutzt werden, die Anschlußflächen 11 auf der Oberfläche der Leiterplatte 1 auszubilden, die beispielsweise als Lötaugen genutzt werden, um elektronische Bauteile mit den Leiterbahnen 3 elektrisch zu verbinden. Darüber hinaus besteht jedoch auch die Möglichkeit, die auf der Außenseite der Prepregs 8 aufgebrachte Leiterfolienschicht 12 zur Ausbildung eines zusätzlichen Leiterbahnenbildes mit Leiterbahnen mit geringer Dicke zu benutzen. Diese Möglichkeit ist dadurch gegeben, daß die Oberfläche der Leiterplatte 1 frei von Leiterbahnen 3 ist. Daraus ergibt sich auch der weitere Vorteil, daß das Aufdrucken einer Lötstoppmaske bei dem erfindungsgemäßen Verfahren bzw. bei der erfindungsgemäßen Leiterplatte 1 nicht erforderlich ist.

Die erfindungsgemäße Leiterplatte 1 hat den Vorteil, daß durch das Verpressen der Leiterplatte 1 mit dem Prepreg 8 ein luftfreies Auffüllen auch sehr tiefer Kanäle 4 und gleichzeitig ein sicheres Abdecken der Kanten 6 der Leiterbahnen 3 möglich ist. Darüber hinaus können für das Basismaterial 2 und für das Prepreg 8 sehr ähnliche Materialien, insbesondere mit Epoxydharz getränktes Glasfasergewebe, benutzt werden, so daß das Basismaterial 2 und das Prepreg 8 ein sehr homogenes Dielektrikum bilden, mit dem eine sehr hohe Dauertemperaturbelastbarkeit möglich ist.

## Patentansprüche

1. Verfahren zur Herstellung von Leiterplatten mit mindestens einem Basismaterial aus Isolierstoff als Träger von Leiterbahnen, wobei die fertigen Leiterbahnen eine Dicke von mindestens 100 µm aufweisen und wobei zunächst auf mindestens einer Seite des Basismaterials eine Leiterfolienschicht aufgebracht wird,
**gekennzeichnet durch** folgende Schritte:
• Strukturieren der Leiterfolienschicht zur Erzeugung der Leiterbahnen,
• Verpressen mit einem isolierenden Füllmaterials, so daß sowohl die Kanäle zwischen den Leiterbahnen mit dem Füllmaterial vollständig gefüllt als auch die Oberfläche der Leiterbahnen von dem Füllmaterial bedeckt sind und
• Anbinden der im Inneren der Leiterplatte angeordneten Leiterbahnen an Anschlußflächen auf der Oberfläche der Leiterplatte **durch** Bohren und Metallisieren von Löchern.

2. Verfahren nach Anspruch 1, **dadurch gekennzeichnet, daß** als Füllmaterial ein Prepreg verwendet wird.

3. Verfahren nach Anspruch 1 oder 2, **dadurch gekennzeichnet, daß** in einem weiteren Schritt zur Erzeugung von Anschlußflächen eine leitfähige Paste auf Bereichen des Füllmaterials aufgebracht wird, wobei die Anschlußflächen elektrisch leitend mit den metallisierten Löchern verbunden werden.

4. Verfahren nach Anspruch 2, wobei das Prepreg auf der dem Basismaterial abgewandten Seite mit einer Leiterfolienschicht beschicht ist, **dadurch gekennzeichnet, daß** in einem weiteren Schritt zur Erzeugung von Anschlußflächen die auf dem Prepreg aufgebrachte Leiterfolienschicht strukturiert wird.

5. Verfahren nach Anspruch 4, **dadurch gekennzeichnet, daß** die Anschlußflächen durch eine oder mehrere der folgende Schritte erzeugt werden:
• Druck eines Plattierungsresists,
• Galvanische Verkupferung bis zur Sollstärke.
• Abscheiden eines Metallresists.
• Strippen des Plattierungsresists und
• Ätzen der Anschlußflächen.

6. Leiterplatte mit mindestens einem Basismaterial (2) aus Isolierstoff als Träger von Leiterbahnen (3), wobei die fertigen Leiterbahnen (3) eine Dicke von mindestens 100 µm aufweisen,
**dadurch gekennzeichnet,**
**daß** ein isolierendes Füllmaterial (8) so auf dem Basismaterial (2) bzw. den Leiterbahnen (3) aufgebracht ist, daß sowohl die Kanäle (4) zwischen den Leiterbahnen (3) mit dem Füllmaterial (8) vollständig gefüllt als auch die Oberfläche (9) der Leiterbahnen (3) von dem Füllmaterial (8) bedeckt sind, und
**daß** Löcher (10) in der Leiterplatte (1) vorgesehen sind, deren Lochwandungen metallisiert sind, so daß die im Inneren der Leiterplatte (1) angeordneten Leiterbahnen (3) elektrisch leitend mit Anschlußflächen (11) auf der Oberfläche der Leiterplatte (1) verbindbar sind.

7. Leiterplatte nach Anspruch 6, **dadurch gekennzeichnet, daß** das Füllmaterial als Prepreg (8) ausgebildet ist, wobei das Prepreg (8) auf der dem Basismaterial (2) abgewandten Seite eine Leiterfolienschicht (12) aufweist.

8. Leiterplatte nach Anspruch 6 oder 7, **dadurch gekennzeichnet, daß** das Basismaterial (2) und das Füllmaterial (8) ähnliche chemische und thermische Eigenschaften aufweisen.

9. Leiterplatte nach Anspruch 8, **dadurch gekennzeichnet, daß** das Basismaterial (2) und das Füllmaterial (8) im wesentlichen aus Epoxydharz und Glasgewebe bestehen.

10. Leiterplatte nach einem der Ansprüche 6 bis 9, **dadurch gekennzeichnet, daß** die Leiterbahnen (3) eine Dicke von ca. 150 µm bis 400 µm, vorzugsweise von etwa 200 µm aufweisen.
